(19) Europäisches Patentamt
European Patent Office
Office européen des brevets

(11) **EP 2 771 908 B1**

(12) **FASCICULE DE BREVET EUROPEEN**

(45) Date de publication et mention
de la délivrance du brevet:
**29.08.2018  Bulletin 2018/35**

(21) Numéro de dépôt: **12787798.3**

(22) Date de dépôt: **23.10.2012**

(51) Int Cl.:
*H01L 21/60* (2006.01)      *H01L 23/498* (2006.01)
*H01L 23/34* (2006.01)

(86) Numéro de dépôt international:
**PCT/FR2012/052416**

(87) Numéro de publication internationale:
**WO 2013/060975 (02.05.2013 Gazette 2013/18)**

(54) **HYBRIDATION FLIP-CHIP DE COMPOSANTS MICROELECTRONIQUES PAR CHAUFFAGE LOCAL DES ELEMENTS DE CONNEXION**

FLIP-CHIP-HYBRIDISIERUNG VON MIKROELEKTRONISCHEN BAUTEILEN DURCH LOKALE ERWÄRMUNG VON VERBINDUNGSELEMENTEN

FLIP-CHIP HYBRIDIZATION OF MICROELECTRONIC COMPONENTS BY LOCAL HEATING OF CONNECTING ELEMENTS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.10.2011  FR 1159639**

(43) Date de publication de la demande:
**03.09.2014  Bulletin 2014/36**

(73) Titulaire: **Commissariat à l'Énergie Atomique et aux Énergies Alternatives**
**75015 Paris (FR)**

(72) Inventeur: **ALIANE, Abdelkader**
**F-38100 Grenoble (FR)**

(74) Mandataire: **Cabinet Laurent & Charras**
**Le Contemporain**
**50 Chemin de la Bruyère**
**69574 Dardilly Cedex (FR)**

(56) Documents cités:
EP-A2- 2 175 485          JP-A- 11 307 918
US-A- 5 010 233           US-A1- 2002 076 535
US-A1- 2002 094 707       US-A1- 2004 101 993
US-A1- 2008 187 772

## Description

### DOMAINE DE L'INVENTION

L'invention a trait au domaine de l'assemblage de composants microélectroniques, et plus particulièrement à l'hybridation face-contre-face également dénommée dans le domaine considéré hybridation « *flip-chip* ».

### ETAT DE LA TECHNIQUE

L'assemblage par la technique dite de *« flip chip »* consiste usuellement à former des billes électriquement conductrices sur une face d'un premier composant électronique, et à former des éléments de connexion électriquement conducteurs, notamment des billes ou des plages de connexions, sur une face d'un second composant selon un motif de connexion prédéterminé. Le premier composant est alors reporté sur le second composant de manière à placer en correspondance les billes avec les éléments de connexion, puis l'ensemble est pressé et chauffé. Les billes se déforment et fondent pour former des connexions électriques perpendiculaires au plan principal des composants électroniques, généralement sous la forme d'une tranche.

La technique la plus classique pour réaliser l'assemblage est de mettre en oeuvre un chauffage global de l'ensemble, par exemple en plaçant les deux composants sous une atmosphère contrôlée en température.

Toutefois, la fusion d'une bille métallique nécessite de hautes températures, typiquement supérieures à 156 °C. Or, ces températures ne sont pas compatibles avec les composants organiques, notamment les composants réalisés en matière plastique tel que le PEN (polyéthylène naphtalate) et le PET (polyéthylène téréphtalate), qui présentent des températures de transition vitreuse inférieures à ces températures, respectivement de 120 °C pour le PEN et de 70°C pour le PET par exemple. Ainsi en soumettant un composant plastique à la température de fusion des billes de soudure, le composant en plastique passe à un état caoutchouteux et se déforme fortement, voire se détruit.

On connaît également des procédés qui mettent en oeuvre un chauffage localisé des billes métalliques. Par exemple, le document US 2008/0187772 A1 divulgue un procédé d'assemblage d'un composant microélectronique muni de billes métalliques sur un substrat muni des plots de connexion correspondants et d'éléments résistifs pour chauffer l'assemblage avec l'application d'un courant électrique. D'ailleurs, le document US 7 810 701 décrit un composant comportant des contacts sous la forme de spirales élastiques recouvertes d'une couche résistive sur lesquels les billes sont déposées. En faisant circuler un courant électrique haute fréquence dans les spirales, il se créer un champ électromagnétique qui entraîne la fusion de la couche résistive et des billes. Ce procédé est donc irréversible et ne permet pas de séparer les deux composants hybridés sans causer leur destruction.

### EXPOSE DE L'INVENTION

Le but de la présente invention est de proposer un procédé et un dispositif permettant de réaliser une hybridation qui soit réversible tout en étant mécaniquement solide, et qui mettent en oeuvre un chauffage localisé des billes métalliques.

A cet effet, l'invention a pour objet un procédé de fabrication d'un dispositif hybridé tel que défini dans les revendications et consistant :

- à réaliser un premier composant microélectronique muni sur une face de billes métalliques, et un second composant micro électronique muni sur une face d'éléments de connexion correspondant auxdites billes métalliques ;
- à mettre en contact les billes du premier composant microélectronique avec les éléments de connexion du second composant microélectronique ; et
- à fixer les billes avec les éléments de connexion.

Selon l'invention telle que définie dans les revendications:

- la réalisation du second composant micro électronique comporte :

  ○ la réalisation d'un substrat ;
  ○ la réalisation, sur une face du substrat, d'éléments résistifs aux emplacements prévus pour les éléments de connexion ;
  ○ le dépôt d'une couche d'isolant électrique au moins sur les éléments résistifs ; et
  ○ la réalisation des éléments de connexion comportant chacun un puits métallique présentant une ouverture apte à recevoir la bille métallique correspondante du premier composant microélectronique et au moins partiellement rempli d'un élément fusible, notamment de l'indium ou un alliage d'étain et d'or, ou d'une encre conductrice, notamment à base d'argent ou de cuivre, la fabrication du puits métallique comportant la réalisation d'une plage métallique sur la couche d'isolant électrique, la plage métallique étant constituée d'un matériau ayant un coefficient de dilatation thermique supérieur à celui du matériau constitutif de la plage d'isolant électrique, et comportant la découpe au laser d'une ouverture dans ladite plage métallique.

  - et la fixation des billes avec les éléments de connexion comporte l'application d'un courant électrique au travers des éléments résistifs de manière à échauffer les billes.

En d'autres termes, les éléments de connexion et les billes sont chauffés localement par convection au travers d'une couche électrique isolante, sans que les éléments de chauffage ne soient eux même détruits. Non seulement, le chauffage est réalisé localement, ce qui limite au maximum l'échauffement du second composant microélectronique, mais en outre, il est possible de deshybrider les deux composant micro électroniques en refaisant circuler du courant dans les éléments chauffants et permettre ainsi leur séparation.

En outre, les puits permet notamment un renforcement mécanique de l'ensemble hybridé. L'encre, recuite lors du chauffage, ou le matériau fusible remplissant partiellement les puits permet de définir une surface mouillable pour les billes et de former un lien électrique avec celles-ci, tout en renforçant également mécaniquement l'interconnexion entre les deux circuits hybridés. La fabrication du puits métallique comporte la réalisation d'une plage métallique et la découpe au laser d'une ouverture dans ladite plage métallique. La gravure laser, par exemple au moyen d'un laser excimère, présente l'avantage de proposer un chauffage très localisé, et de limiter ainsi les effets thermiques indésirables sur le second composant microélectronique, tout en permettant un apport important d'énergie photonique. La taille de l'ouverture du puits est par exemple réglée au moyen de la différence de coefficient de dilatation thermique entre le matériau de la plage métallique et le matériau du substrat.

Selon un mode de réalisation, l'isolant électrique est un polymère fluoré à faible constante diélectrique, notamment une constante diélectrique égale ou proche de 2. Les polymères fluorés présentent une très grande stabilité chimique, une très haute température de fusion ainsi qu'une très bonne conductivité thermique. En outre, l'isolant est avantageusement obtenu en appliquant un recuit avec une pente rapide à une émulsion de ce polymère dans un ou plusieurs solvants, ce qui permet d'évaporer très rapidement le ou les solvants contenus dans ladite émulsion, ce qui engendre des micropores remplis d'air dans l'isolant finalement obtenu.

Selon un mode de réalisation, les éléments résistifs sont réalisés sous la forme de serpentins ou de tiges. Notamment, les éléments résistifs sont connectés en série. Les éléments résistifs présentent donc une forte résistance électrique. Il est ainsi possible d'obtenir un échauffement élevé avec un courant faible et/ou très rapidement.

Selon un mode de réalisation, lors de l'application du courant, la face du second composant microélectronique, opposée à la face munie des éléments de connexion, est refroidie, ce qui permet de diminuer l'impact du chauffage, même local, sur le second composant microélectronique.

Selon un mode de réalisation, le substrat du second composant microélectronique comprend du plastique, notamment du PEN ou du PET. Par exemple, le substrat est un substrat flexible.

## BREVE DESCRIPTION DES FIGURES

La présente invention sera mieux comprise à la lecture de la description qui va suivre, donnée uniquement à titre d'exemple, et réalisée en relation avec les dessins annexés, dans lesquels des références identiques désignent des éléments identiques ou analogues, et dans lesquels :

- la figure 1 est une vue en coupe schématique d'un dispositif réalisé selon le procédé de l'invention et comportant deux composants microélectroniques hybridés ;
- les figures 2 à 12 sont des vues schématiques illustrant un procédé de fabrication selon l'invention ;
- les figures 13 et 14 sont des vues schématique illustrant un procédé de fabrication alternatif au procédé selon l'invention ;
- la figure 15 est une vue schématique de dessus d'un composant microélectronique muni d'éléments résistifs selon l'invention ; et
- la figure 16 est une vue en perspective d'un élément résistif.

## DESCRIPTION DETAILLEE DE L'INVENTION

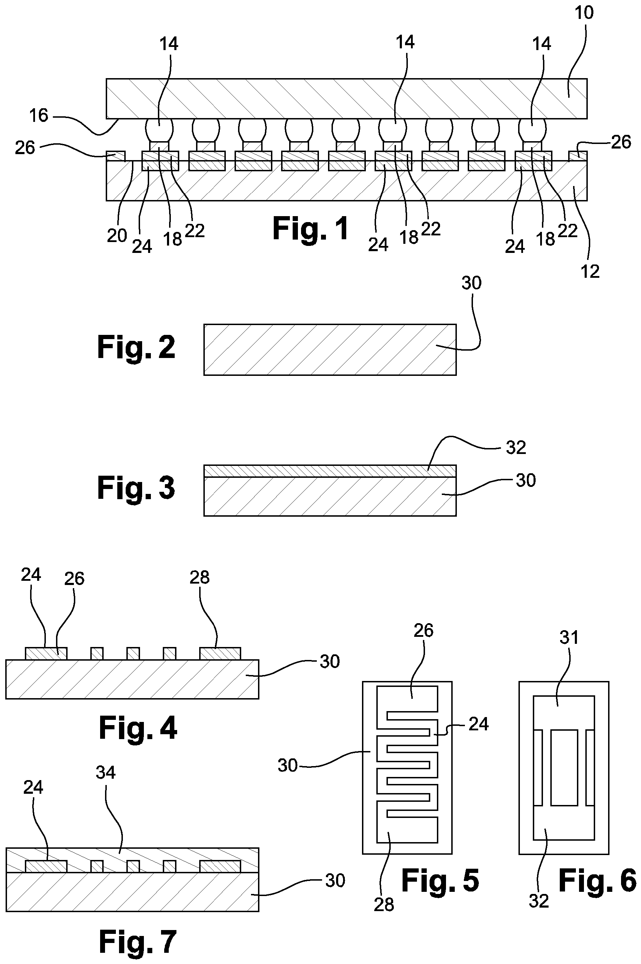

Sur la figure 1, un dispositif réalisé selon le procédé de l'invention comporte un premier composant micro électronique **10,** par exemple une puce micro électronique à base de silicium, hybridé sur un second composant microélectronique **12.**

L'hybridation des deux composants **10** et **12** est réalisée au moyen de billes métalliques **14** disposées sur des surfaces mouillables d'une face **16** du premier composant **10,** et fixées mécaniquement à des éléments de connexion correspondants **18** disposés sur une face **20** du second composant **12,** comme cela sera décrit plus en détail par la suite.

Chaque élément de connexion **18** est par ailleurs formé sur une couche réalisée en un matériau isolant électriquement **22,** notamment une couche de diélectrique, déposée sur un élément résistif **24** formé sur, et/ou dans le second composant **12.** Enfin, des bornes métalliques **26** sont prévues sur et/ou dans le second composant **12** pour l'application d'un courant électrique dans les éléments résistifs **24.**

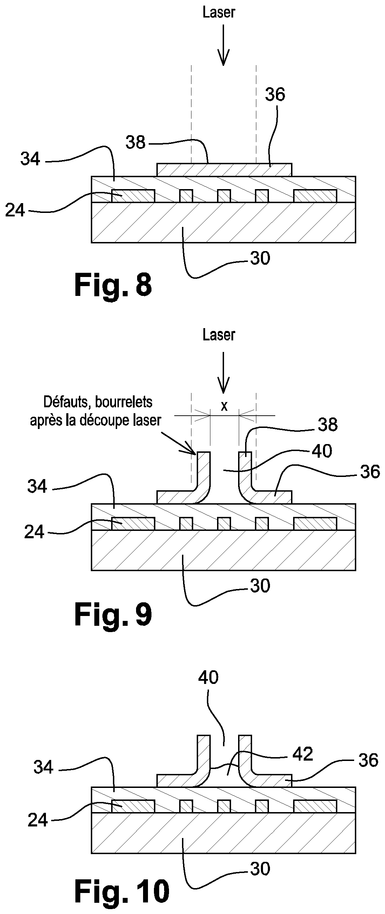

Il va à présent être décrit plus en détail en relation avec les figures 2 à 12 un procédé de fabrication du dispositif venant d'être décrit selon l'invention.

Le procédé débute par la fabrication d'un substrat **30** du second composant **12** (figure en coupe 2). Le substrat **30** est par exemple un substrat flexible en plastique, constitué notamment de PET ou de PEN, un substrat en silicium comportant des circuits microélectroniques, ou autres.

Une couche métallique **32** est ensuite déposée pleine plaque sur une face du substrat **30,** par exemple par évaporation ou pulvérisation (figure en coupe 3). La couche **32** est par exemple une couche d'or, de titane, de nickel, de cuivre ou de tungstène et présente une épaisseur comprise entre 30 nanomètres et 300 nanomètres, afin de conserver le caractère flexible du substrat **30** en limitant les effets de la différence entre le coefficient de dilatation thermique du substrat **30** et celui de la couche métallique **32**.

La couche **32** est ensuite gravée afin de former les éléments résistifs **24**. La forme des éléments **24** est choisie en fonction l'échauffement local souhaité lors de l'hybridation des composants **10, 12**.

De préférence, les éléments **24** sont filiformes et présentent une grande longueur curviligne pour une faible largeur et/ou une faible hauteur, ce qui permet de définir une grande résistance électrique, et corolairement un fort échauffement par effet Joule. Les éléments résistifs **24** sont par exemple constitués de serpentins agencés chacun entre deux plages **26, 28** (figure de dessus 5) ou un ensemble de bandes ou tiges, par exemple deux bandes, connectées en parallèle entre deux plages **30, 32** (figure de dessus 6). Le matériau et l'épaisseur de la couche **32**, et donc des éléments résistifs **24**, sont également choisis en fonction de l'échauffement local souhaité lors de l'hybridation des composants **10, 12**, comme cela sera expliqué plus en détail par la suite.

Les éléments **24** peuvent également être réalisés en déposant localement la couche **32** et en gravant celle-ci, ou directement par exemple au moyen d'une photolithographie et d'une gravure.

Le procédé se poursuit par le dépôt d'une couche **34** d'isolant électrique, par exemple une couche de diélectrique, au moins sur les éléments résistifs **24** (figure en coupe 7) afin d'éviter tout court-circuit entre ceux-ci et les éléments de connexion **18** fabriqués ultérieurement, et donc également afin d'éviter tout court-circuit entre les éléments résistifs **24** et les billes métalliques **14** du premier composant **10**. La couche **34** est par exemple déposée pleine plaque sur la totalité du substrat **30**, ou bien uniquement sur les éléments résistifs **24**.

De préférence, la couche **34** est constituée d'un matériau qui est également un bon conducteur de chaleur et qui présente une température de fusion plus élevée que celle des billes métalliques **14**, de manière à éviter la fusion de la couche **34** lors de l'hybridation. Avantageusement, la couche **34** est ainsi constituée d'un polymère fluoré à faible constante diélectrique qui présente une grande stabilité chimique ainsi qu'une bonne conduction de la chaleur si on le recuit très rapidement. La couche **34** est par exemple déposée par sérigraphie ou par jet d'encre.

Une plage métallique **36** ou plage dite « UBM » (pour l'expression anglo-saxonne *« Under Bump Metallization »*), est ensuite déposée sur la couche isolante **34** au droit de chaque élément résistif **24**, cette couche étant typiquement constituée d'or, de titane, de nickel, de cuivre ou de tungstène, et par exemple constituée du même métal que les éléments résistifs **24** (figure en coupe 8).

Une zone centrale **38** de chaque plage **36** est ensuite soumise à un échauffement local, au moyen d'un laser, par exemple du type excimère, qui permet de limiter les effets thermiques sur le substrat **30** tout en apportant une importante énergie photonique.

Sous l'effet de la chaleur localisée, la plage métallique **36** et la couche isolante **34** se dilatent. Comme les matériaux constitutifs de ceux-ci sont différents, la plage **36** et la couche **34** présentent donc des coefficients de dilations thermiques différents, le métal de la plage **36** présentant un coefficient supérieur à celui de la couche **34**.

Sous l'effet de l'échauffement, il résulte donc un différentiel de dilation qui provoque le détachement de la zone centrale **36** et la formation d'un ou plusieurs bourrelets définissant un puits **40** (figure en coupe 9). La largeur $x$ du puits **40** est notamment déterminée par la différence de coefficient de dilatation thermique de la plage **36** et de la couche **34** et est choisie pour être supérieure au diamètre de la bille **14** qui sera ultérieurement introduite dans le puits **40**. Ceci permet notamment d'ajuster la dimension du puits **40** en fonction de la température de l'élément chauffant **24** lors d'hybridation mais également de la dé-hybridation. Notamment, le chauffage localisé augmente les différences de dilatation de la plage **36** et de la couche **34**, ce qui ouvrir d'avantage les puits **40** pour recevoir les billes **14**.

Le procédé se poursuit par le dépôt, par exemple par sérigraphie ou par jet d'entre, d'une encre conductrice **42** dans chaque puits **40**, notamment une encre métallique à base d'argent ou de cuivre (figure en coupe 10). L'encre **42** permet notamment le mouillage d'une bille métallique **14** introduite dans le puits **40** lors de l'hybridation, et forme avec cette bille un lien électrique. La présence de l'encre **42** permet ainsi d'utiliser des billes **14** qui ne mouillent pas, ou très peu avec le métal de la plage **36**, comme par exemple des billes **14** en or.

Le procédé se poursuit alors par l'hybridation proprement dite des composants micro électroniques **10** et **12**.

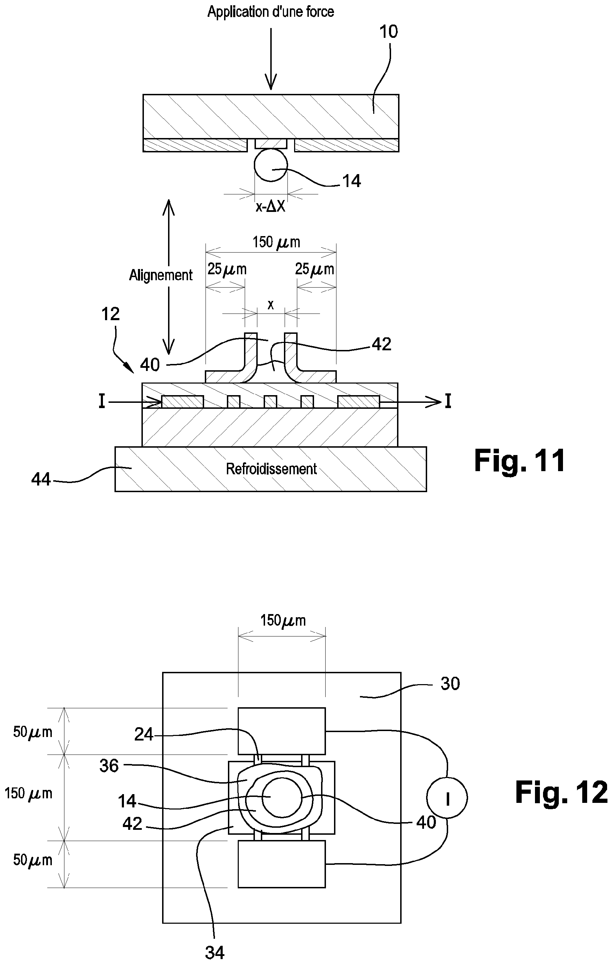

Plus particulièrement, le premier composant **10** est reporté sur le second composant **12** en alignant ceux-ci, puis en appliquant une force au premier composant **10** (figure 11), de manière à introduire les billes **14** dans les puits **40**, et ainsi mettre les billes **14** au contact de l'encre **42** (figure 12).

La face du second composant **12**, opposée à celle munie des éléments de connexion **22** constitués des puits **40** et de l'encre **42**, est par ailleurs mise au contact d'un système de refroidissement, par exemple une plaque réfrigérée **44**.

Enfin, un courant électrique $I$ est appliqué à chacun des éléments résistifs **24** qui s'échauffent alors par effet joule. La chaleur produite est transférée par convection aux billes **14** qui fondent, l'encre **42** subissant en outre un recuit qui va d'avantage augmenter la conductivité de celle-ci par l'évaporation totale des solvants présents dans cette encre métallique. La plage **36** ne fond pas sous l'effet du chauffage car sa température de fusion est choisie plus élevée que la température obtenue par le chauffage. Notamment le matériau constitutif de la plage **36** présente une température de fusion supérieure à celle des billes **14**. Une fois les billes fondues, l'injection du courant $I$ est coupée, et les billes **14** se refroidissent et solidifient. Les puits **40** permettent notamment de renforcer la tenue mécanique des composants hybridés **10, 12**.

Selon une variante de réalisation, les billes **14** et le métal de la plage **36** sont choisis de manière à ce que les billes mouillent le métal **36**. Par exemple, les billes **14** sont constituées d'un métal dit de « soudure », comme par exemple l'indium, l'étain et les alliages d'or et d'étain. L'encre **42** est alors omise.

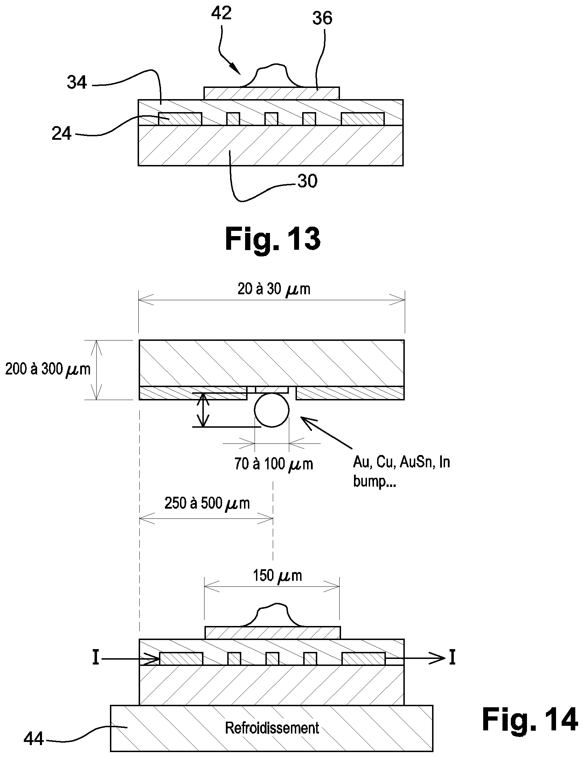

Il va être décrit en relation avec les figures 13 et 14 un procédé de fabrication alternatif au procédé selon l'invention.

Ce procédé débute par exemple de manière identique aux étapes décrites en relation avec les figures 2 à 8. A la différence du procédé selon l'invention, le procédé se poursuit par le dépôt direct de l'encre **42** sur les plages métalliques **36** sans formation de puits **40** (figure en coupe 13). Comme pour le procédé selon l'invention, l'encre permet l'usage de billes métalliques qui ne mouillent pas ou très peu la plage métallique **36**, tout en assurant un lien électrique entre les billes et les plages **36**.

Le premier composant **10** est ensuite reporté sur le second composant **12** en alignant les billes **14** avec les plages **36** (figure 14). La face du second composant **12**, opposée à celle munie des éléments de connexion **22** constitués des plages **36** et de l'encre **42**, est ensuite refroidie comme précédemment décrit, et un courant électrique $I$ est appliqué à chacun des éléments résistifs **24** qui s'échauffent par effet Joule. La chaleur produite est alors transférée par convection aux billes **14** qui fondent, l'encre **42** subissant en outre un recuit.

Selon une variante de réalisation, les billes **14** et le métal de la plage **36** sont choisis de manière à ce que les billes mouillent le métal **36**. Par exemple, les billes **14** sont constituées d'un métal dit de « soudure », comme par exemple l'indium et les alliages d'or et d'étain. L'encre **42** est alors omise.

Les dispositifs hybridés ainsi obtenus peuvent être dés-hybridés de manière simple. Il suffit en effet de faire circuler à nouveau un courant dans les éléments résistifs **24,** qui n'ont pas été détruits lors de l'hybridation, de manière à induire à nouveau la fusion des billes **14**, ce qui permet de détacher les composants **10, 12**.

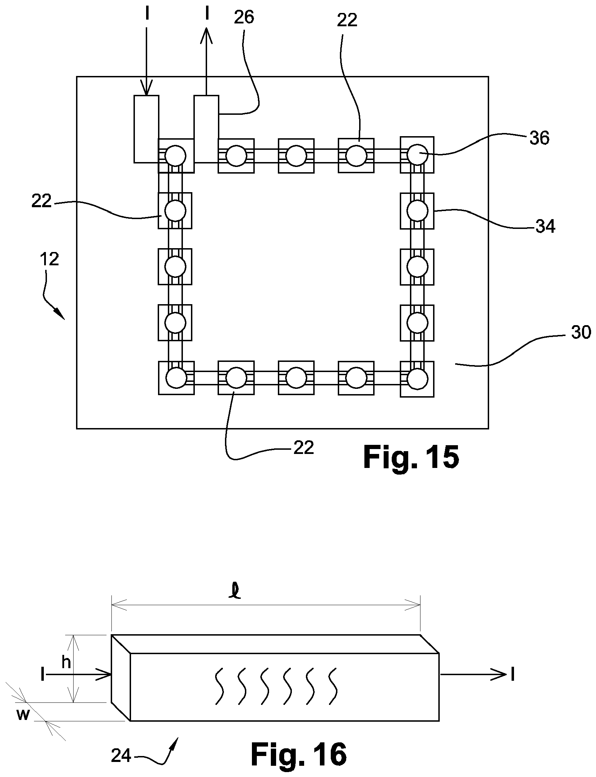

La figure 15, qui est une vue de dessus d'un exemple de réalisation du second composant **30,** illustre un schéma de connexion des éléments résistifs **24**. De manière avantageuse, les éléments résistifs **24** sont connectés en série, de sorte qu'ils sont parcourus par un même courant, compris par exemple entre 1 mA et 300 mA, et s'échauffent de manière sensiblement identique dès lors qu'ils sont eux mêmes identiques. Par exemple, les éléments **24** sont formés à partir d'un unique ruban métallique conducteur dont les extrémités forment les bornes **26** pour l'application du courant $I$. Le courant est par exemple injecté par une source de courant par l'intermédiaire d'un miroir de courant.

La figure 15 illustre en outre un agencement d'élément de connexion correspondant **22** à un scellement périphérique du premier circuit **10** sur le second circuit **12**. Bien entendu, le motif d'hybridation dépend de l'application visée.

La figure 16 est une vue en perspective d'un élément **24** sous la forme d'un élément rectiligne, étant entendu que ce qui suit reste valable pour des éléments non rectilignes, la longueur $l$ à considérer étant la longueur curviligne de l'élément.

On montre que l'échauffement $\Delta T$ par seconde d'un élément **24** traversé par un courant d'intensité $I$ est modélisable au premier degré selon la relation :

$$\Delta T = \frac{\rho \times l^2}{2 \times k_p \times w^2 \times h^2} \times I^2$$

où :

- $\rho$ est la résistivité par mètre du matériau constitutif de l'élément **24,** en $\Omega/m$;
- $l$ est la longueur en mètre de l'élément **24 ;**
- $w$ est la largeur en mètre de l'élément **24 ;**
- $h$ est la hauteur en mètre de l'élément **24 ;**
- $k_p$ est la conductivité thermique du matériau constitutif de l'élément **24,** en $W/K.m$ ; et
- $I$ est l'intensité en ampère du courant traversant l'élément **24**.

On dispose donc de plusieurs paramètres, à savoir les dimensions de l'élément **24,** la nature du ou des matériaux le constituant, ainsi que la valeur du courant le traversant, pour contrôle l'échauffement produit par celui-ci. Notamment, il est possible de choisir des éléments **24** qui permettent un échauffement très intense et/ou très rapide des billes métalliques **14**.

Il a été décrit des dispositifs et procédé d'hybridation dans lesquels il est obtenu une fusion des billes métalliques.

L'invention s'applique également à des hybridations dans lesquels les billes ne sont pas fondues. Notamment, on connaît des insertions dites « à froid » dans lequel des éléments de connexion protubérants, par exemple des cylindres creux, sont insérés en force dans des billes en matériau ductile. Une telle hybridation est par exemple décrite dans le document US-A-2011/0035925. Dans un tel procédé d'hybridation il est possible de chauffer localement les billes afin de les ramollir, sans les faire fondre, et ainsi faciliter l'insertion de l'élément de connexion dans la bille.

## Revendications

1. Procédé de réalisation d'un dispositif hybridé consistant :

   ■ à réaliser un premier composant microélectronique (10) muni sur une face de billes métalliques (14), et un second composant microélectronique (12) muni sur une face d'éléments de connexion (40 ; 40, 42 ; 36 ; 36, 42) correspondant auxdites billes métalliques (14) ;

   ■ à mettre en contact les billes (14) du premier composant microélectronique (10) avec les éléments de connexion (40 ; 40, 42 ; 36 ; 36, 42) du second composant microélectronique (12) ; et

   ■ à fixer les billes (14) avec les éléments de connexion (40 ; 40, 42 ; 36 ; 36, 42) ;

   ■ dans lequel la fabrication du second composant microélectronique (12) comporte :

   ○ la réalisation d'un substrat (30) ;
   ○ la réalisation, sur une face du substrat, d'éléments résistifs (24) aux emplacements prévus pour les éléments de connexion (40 ; 40, 42 ; 36 ; 36, 42) ;
   ○ le dépôt d'une couche d'un isolant électrique (34) au moins sur les éléments résistifs (24) ; et
   ○ la réalisation des éléments de connexion (40 ; 40, 42) comportant chacun un puits métallique (40) présentant une ouverture apte à recevoir la bille métallique (14) correspondante du premier composant microélectronique (10) et au moins partiellement rempli d'un élément fusible, notamment de l'indium ou un alliage d'étain et d'or, ou d'une encre conductrice (42), notamment à base d'argent ou de cuivre ;

   ■ et la fixation des billes (14) avec les éléments de connexion (40 ; 40, 42 ; 36; 36, 42) comporte l'application d'un courant électrique au travers des éléments résistifs (24) de manière à échauffer les billes (14)

   ■ **caractérisé en ce que** la fabrication du puits métallique (40) comporte :

   ○ la réalisation d'une plage métallique (36) sur la couche d'isolant électrique (34), la plage métallique étant constituée d'un matériau ayant un coefficient de dilatation thermique supérieur à celui du matériau constitutif de la plage d'isolant électrique (34) ;
   ○ et la découpe au laser d'une ouverture dans ladite plage métallique (36).

2. Procédé de réalisation d'un dispositif hybridé selon la revendication 1, *caractérisé* **en ce que** l'isolant électrique (34) est un polymère fluoré.

3. Procédé de réalisation d'un dispositif hybridé selon l'une quelconque des revendications précédentes, *caractérisé* **en ce que** les éléments résistifs (24) sont réalisés sous la forme de serpentins ou de tiges.

4. Procédé de réalisation d'un dispositif hybridé selon l'une quelconque des revendications précédentes, *caractérisé* **en ce que** les éléments résistifs (24) sont connectés en série.

5. Procédé de réalisation d'un dispositif hybridé selon l'une quelconque des revendications précédentes, *caractérisé* **en ce que** lors de l'application du courant, la face du second composant microélectronique (12), opposée à la face munie des éléments de connexion, est refroidie.

6. Procédé de réalisation d'un dispositif hybridé selon l'une quelconque des revendications précédentes, *caractérisé* **en ce que** le substrat (30) du second composant microélectronique (12) comprend du plastique, notamment du PEN ou du PET.

## Patentansprüche

1. Verfahren zur Herstellung einer hybridisierten Vorrichtung, bestehend aus:

   - Herstellung einer ersten mikroelektronischen Komponente (10), die auf einer Seite mit Metallhöckern (14) versehen ist, und einer zweiten mikroelektronischen Komponente (12), die auf einer Seite mit Verbindungselementen (40 ; 40, 42 ; 36 ; 36, 42) versehen ist, die diesen Metallhöckern (14) entsprechen;
   - die Metallhöcker (14) der ersten mikroelektronischen Komponente (10) in Kontakt mit den Verbindungselementen (40 ; 40, 42 ; 36 ; 36, 42) der zweiten mikroelektronischen Komponente (12) zu bringen; und
   - Befestigen der Höcker (14) an den Verbindungselementen (40; 40, 42; 36; 36, 42);
   bei dem die Herstellung der zweiten mikroelektronischen Komponente (12) umfasst:

   * Herstellung eines Substrats (30);
   * Herstellung von Widerstandselementen (24) auf einer Seite des Substrats an den Stellen, die für die Verbindungselemente (40; 40, 42; 36; 36, 42) vorgesehen sind;
   * Abscheiden einer elektrischen Isolatorschicht (34) zumindest auf den Widerstandselementen (24), und
   * Herstellung von Verbindungselementen (40; 40, 42), die jeweils eine Metallvertiefung (40) enthalten, die eine Öffnung aufweist, die den entsprechenden Metallhöcker (14) der ersten mikroelektronischen Komponente (10) aufnehmen kann und mindestens teilweise mit einem schmelzbaren Element, insbesondere Indium oder einer Legierung aus Zinn und Gold, oder mit einer leitfähigen Tinte (42), insbesondere auf der Basis von Silber oder Kupfer, gefüllt ist;

und die Befestigung der Höcker (14) mit den Verbindungselementen (40; 40, 42; 36; 36, 42) umfasst das Anlegen eines elektrischen Stroms durch die Widerstandselemente (24), um die Höcker (14) zu erwärmen; **dadurch gekennzeichnet, dass** die Herstellung der Metallvertiefung (40) umfasst: * die Herstellung einer Metallplatte (36) auf der elektrischen Isolatorschicht (34), die Metallplatte besteht dabei aus einem Material mit einem Wärmeausdehnungskoeffizienten der höher ist als der des Materials, das die elektrische Isolatorschicht (34) - Platte bildet; * und dem Ausschneiden mit dem Laser einer Öffnung in dieser Metallplatte (36).

**2.** Verfahren zur Herstellung einer hybridisierten Vorrichtung, nach Anspruch 1, **dadurch gekennzeichnet, dass** die elektrische Isolatorschicht (34) ein Fluorpolymer ist.

**3.** Verfahren zur Herstellung einer hybridisierten Vorrichtung, nach irgendeinem der vorhergehenden Ansprüche, **dadurch gekennzeichnet, dass** die Widerstandselemente (24), in Form von Wendeln oder Stangen ausgeführt sind.

**4.** Verfahren zur Herstellung einer hybridisierten Vorrichtung, nach irgendeinem der vorhergehenden Ansprüche, **dadurch gekennzeichnet, dass** die Widerstandselemente (24) in Serie geschaltet sind.

**5.** Verfahren zur Herstellung einer hybridisierten Vorrichtung, nach irgendeinem der vorhergehenden Ansprüche, **dadurch gekennzeichnet, dass** beim Anlegen des Stroms die Seite der zweiten mikroelektronischen Komponente (12), die der Seite mit den Verbindungselementen entgegengesetzt ist, gekühlt wird.

**6.** Verfahren zur Herstellung einer hybridisierten Vorrichtung, nach irgendeinem der vorhergehenden Ansprüche, **dadurch gekennzeichnet, dass** das Substrat (30) der zweiten mikroelektronischen Komponente (12) Kunststoff enthält, insbesondere PEN oder PET.

**Claims**

**1.** A method of forming a hybridized device comprising:

- forming a first microelectronic component (10) provided on a surface with metal bumps (14), and a second microelectronic component (12) provided on a surface with connection elements (40; 40, 42; 36; 36, 42) corresponding to said metal bumps (14);
- placing the bumps (14) of the first microelectronic component (10) into contact with the connection elements (40; 40, 42; 36; 36, 42) of the second microelectronic component (12); and
- attaching the bumps (14) to the connection elements (40; 40, 42; 36; 36, 42); in which the manufacturing of the second microelectronic component (12) comprises:

  ◦ forming a substrate (30);
  ◦ forming, on a surface of the substrate, resistive elements (24) at the locations provided for the connection elements (40; 40, 42; 36; 36, 42);
  ◦ depositing an electric insulator layer (34) at least on the resistive elements (24); and
  ◦ forming the connection elements (40; 40, 42), each comprising a metal well (40) having an opening capable of receiving the corresponding metal bump (14) of the first microelectronic component (10) and at least partially filled with a fusible element, particularly indium or an alloy of tin and gold, or with a conductive ink (42), particularly based on silver or copper;

  and in which the attachment of the bumps (14) to the connection elements (40; 40, 42; 36; 36, 42) comprises applying an electric current through the resistive elements (24) to heat the bumps (14) ;
  **characterized in that** the manufacturing of the metal well (40) comprises:
  • forming a metal area (36) on the electric insulator layer (34), said metal area (36) being made of a material provided with a thermal expansion coefficient superior than that of the material constituting the electric insulator layer (34), and
  • cutting with a laser an opening in said metal area (36).

**2.** The method of forming a hybridized device of claim 1, wherein the electric insulator (34) is a fluorinated polymer.

**3.** The method of forming a hybridized device of any of the foregoing claims, wherein the resistive elements (24) are made in the form of coils or of rods.

4. The method of forming a hybridized device of any of the foregoing claims, wherein the resistive elements (24) are series-connected.

5. The method of forming a hybridized device of any of the foregoing claims, wherein on application of the current, the surface of the second microelectronic component (12), opposite to the surface provided with the connection elements, is cooled down.

6. The method of forming a hybridized device of any of the foregoing claims, wherein the substrate (30) of the second microelectronic component (12) comprises plastic, particularly PEN or PET.

Fig. 1

Fig. 2

Fig. 3

Fig. 4

Fig. 5

Fig. 6

Fig. 7

Fig. 8

Fig. 9

Fig. 10

Application d'une force

10

14

x-ΔX

150 μm

25 μm          25 μm

Alignement

x

12

40          42

I ——————→ I

Refroidissement

44

**Fig. 11**

150μm

30

50μm

24

36

14

42          40

I

**Fig. 12**

50μm

150 μm

34

42    36

34

24

30

**Fig. 13**

20 à 30 $\mu$m

200 à 300 $\mu$m

70 à 100 $\mu$m

Au, Cu, AuSn, In
bump...

250 à 500 $\mu$m

150 $\mu$m

I                                    I

Refroidissement

44

**Fig. 14**

**Fig. 15**

**Fig. 16**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20080187772 A1
- US 7810701 B
- US 20110035925 A